# EUROPÄISCHE PATENTSCHRIFT

(11) **EP 1 580 564 B1**
(45) Veröffentlichungstag und Bekanntmachung des Hinweises auf die Patenterteilung: **13.09.2006**
(21) Anmeldenummer: 05002348.0
(22) Anmeldetag: 04.02.2005
(51) Int. Cl.: G01R 19/08, H01M 8/04

(54) **Verfahren zur Bestimmung der Stromdichteverteilung in Brennstoffzellen**
Method of determination of current density distribution in fuel cells
Procédé de détermination de la distribution de la densité de courant dans les piles à combustible

(30) Priorität: 23.03.2004 DE 102004014493
(43) Veröffentlichungstag der Anmeldung: 28.09.2005
(73) Patentinhaber: Forschungszentrum Jülich GmbH, 52425 Jülich (DE)
(72) Erfinder: Wüster, Thorsten, 52076 Aachen (DE); Ghosh, Prakash, Dr., 52428 Jülich (DE); Dohle, Hendrik, Dr., 52224 Stolberg (DE); Mergel, Jürgen, 52428 Jülich (DE)

(56) Entgegenhaltungen:
- DE-A1- 10 213 478
- US-A1- 2004 018 401
- GLEGHORN S J C ET AL: "A printed circuit board approach to measuring current distribution in a fuel cell" JOURNAL OF APPLIED ELECTROCHEMISTRY, CHAPMAN AND HALL, LONDON, GB, Bd. 28, Nr. 7, Juli 1998 (1998-07), Seiten 663-672, XP002130361 ISSN: 0021-891X

## Beschreibung

Die Erfindung betrifft ein Verfahren, mit der die Stromdichteverteilung in einer Brennstoffeinzelzelle, und insbesondere auch in kompletten Brennstoffzellenstapeln ermittelt werden kann.

### Stand der Technik

Die Wirkungsweise und damit die Effektivität einer Brennstoffzelle ist einerseits stark von der Betriebsführung der Brennstoffzelle, insbesondere von dem Wasser- und Wärmemanagement, und andererseits vom Design und der Bauweise, beispielsweise der Geometrie der Betriebskanäle, abhängig. Während der Betriebsführung einer Brennstoffzelle treten regelmäßig Inhomogenitäten innerhalb der Brennstoffkonzentration entlang der Betriebsmittelverteilerplatte, auch Flow field genannt, auf, welche regelmäßig zu Inhomogenitäten in der Stromverteilung entlang der Elektrode führen. Diese Inhomogenitäten sind allerdings an der Außenseite einer Brennstoffzelle nicht zu erkennen, da dort in der Regel nur der gesamte Zellenstrom, bzw. die gesamte Zellspannung abgegriffen werden kann. Neben der Brennstoffkonzentration beeinflussen auch das Wassermanagement und die Temperaturverteilung die Stromverteilung in einer Zelle.

Die Optimierung dieser Faktoren setzt daher insbesondere die genaue Kenntnis der lokalen Stromdichteverteilung in der Einzelzelle bzw. in dem Brennstoffzellenstapel voraus.

Um die zunächst in Simulationen berechneten mathematischen Ergebnisse zu bestätigen, sind insbesondere praktische Untersuchungen notwendig, die zudem ein besseres Verständnis für die elektrochemischen Reaktionen im Inneren einer Brennstoffzelle geben sollen. Bislang sind jedoch nur einige wenige Experimente an Polymer-Elektrolytmembran-Brennstoffzellen (PEM) und an Direkt-Methanol-Brennstoffzellen (DMFC) [1-4] veröffentlicht worden, die sich mit der Stromdichteverteilung in einer Einzelzelle beschäftigt haben.

Bei Stumper et al. [3] werden gleich mehrere unterschiedliche Methoden vorgestellt, die Informationen über die Stromdichteverteilung liefern können. Dies sind die Partielle Membran-Elektroden-Einheit (MEA)-Methode, bei der nur ein Teil der Membran mit Katalysator belegt wird. Durch Messung an unterschiedlichen Bereichen der Membran kann so auf die Stromdichteverteilung geschlossen werden. Bei der Unterzellenmethode sind einige Bereiche der Membran-Elektroden-Einheit und passend dazu in der Anode und der Kathode vom Rest der Zelle isoliert und werden zur Auslesung separat angesteuert. Bei der Stromabbildungstechnik werden zwischen die Strömungsfeldplatte und die ableitende Platte Widerstände geschaltet. Der Spannungsabfall an diesen Widerständen kann als Maß für den Strom genommen werden.

Cleghorn et al. [8] offenbart eine segmentierte Anode für eine Brennstoffzelle. Sie ist aus einer durchkontaktierten gedruckten Leiterplatte gefertigt. Ein Segment wird mit einer erster Kontaktspannungsquelle verbunden und der durch das Segment fließende Strom kann gemessen werden. Die übrigen Segmente werden mit einer zweiten Kontaktspannungsquelle verbunden. Durch Umschaltung zwischen den Segmenten kann so der Strom durch alle Segmente gemessen werden.

Eine gedruckte Leiterplatte wird auch bei Brett et al. in [2] eingesetzt, wobei isolierte Stromsammler geschaffen wurden, um eine Segmentierung der Zelle zu umgehen.

Bei Schönbauer et al. in [7] wurde eine gedruckte Schaltung in eine Bipolarplatte eingebracht, so dass die Stromverteilung nicht nur in einer Einzelzelle, sondern vorteilhaft in einem Brennstoffzellenstapel gemessen werden konnte.

Noponen et al. berichten in [5] über die Messung der Stromdichteverteilung einer segmentierten Kathode einer freiblasenden Brennstoffzelle.

Bei Wieser et al. [1] werden Hallsensoren in eine segmentierte Flow field Platte eingesetzt, um das magnetische Feld zu messen, welches sich aus dem Stromfluss in der elektrochemischen Zelle ergibt. Die Stromdichteverteilung lässt sich dann daraus zurückrechnen. Es wird eine Versuchsanordnung für eine 600 cm² große Elektrodenfläche mit 5 x 8 Stromsensoren dargestellt.

Rajalakshimi et al. [6] und Yoon et al. [9] offenbaren eine segmentierte Einzelzelle, bei der ebenfalls das magnetische Feld gemessen, und die Stromdichteverteilung daraus errechnet wird. Dabei wird das segmentierte Flow field sowohl an der Kathodenseite, als auch an der Anodenseite eingesetzt.

In DE 100 03 584 A1 wird ein Verfahren beschrieben, welches die Stromdichteverteilung in einer Brennstoffzelle über die Vermessung des äußeren Magnetfeldes bestimmt.

Aus DE 102 13 479 A1 ist ein Verfahren und eine Vorrichtung zur Bestimmung der Stromdichteverteilung, der Temperaturverteilung und der Druckverteilung über den Querschnitt eines Leiters bekannt, bei dem Messzellen zu einer Matrix angeordnet werden. Die Messzellen einer Zeile werden jeweils durch eine Signal aktiviert. An den Spalten wird dann ein Signal abgegriffen, welches dem zu messenden Strom proportional ist.
In DE 101 51 601 A1 wird ein Gasverteilungselement zur Reaktionsgaszuführung zu einer oder mehreren elektrochemischen Elektroden, insbesondere Brennstoffzellenelektroden beschrieben. In dieses Element ist eine Messplatine integriert, über die eine lokale Stromverteilung messbar ist. Dabei ist zur elektrischen Kontaktierung einer Elektrode eine Mehrzahl von Stromableitungselementen vorgesehen, die einzeln kontaktiert sind.

Allen vorgenannten Messmethoden ist gemein, dass die Bestimmung der Verteilung der Stromdichte nur mit hohem Verdrahtungsaufwand und/oder aber mit einer relativ schlechten Auflösung erfolgte.

Die Stromdichte charakterisiert die Leistungsfähigkeit einer Brennstoffzelle. Sie wird üblicherweise in mA/cm² gemessen. Weil diese Kenngröße auch von der Zellspannung abhängt, bezieht man die Stromdichte üblicherweise auf eine Zellspannung zwischen 0,6 und 0,7 V. Die Stromdichte ist abhängig von der effektiven Zellfläche der Elektroden. Diese ist aufgrund ihrer porösen Gestaltung der Oberfläche in der Regel um ein Vielfaches größer als ihre mechanische Fläche. Eine Linearität zwischen den beiden Größen existiert aber in der Regel nicht. Eine Verdoppelung der Zellfläche führt also nicht zwangläufig zu einer Verdoppelung der Stromdichte.

Allen diesen vorgenannten Verfahren ist die Segmentierung der Brennstoffzelle teilweise oder komplett gemeinsam. Dies führt aber zwangsläufig zu einer Abweichung des Verhaltens der Brennstoffzelle in diesem Versuchsaufbau verglichen mit dem üblichen Betrieb einer unsegmentierten Zelle.

### Aufgabe und Lösung

Die Aufgabe der Erfindung ist es, ein Verfahren zur Ermittlung der lokalen Stromdichtverteilung innerhalb einer Einzelzelle oder eines Brennstoffzellenstapel zur Verfügung zu stellen, welches einen deutlich geringeren Verkabelungsaufwand benötigt, als bislang nach den bekannten Stand der Technik benötigt wird.

Die Aufgabe der Erfindung wird gelöst durch ein Verfahren mit der Gesamtheit an Merkmalen gemäß Hauptanspruch. Vorteilhafte Ausgestaltungen des Verfahrens finden sich in den jeweils rückbezogenen Unteransprüchen.

### Gegenstand der Erfindung

Das erfindungsgemäße Verfahren zur Bestimmung von Stromdichteverteilungen in einer Brennstoffzelle basiert auf der Ermittlung einzelnen Potentialdifferenzen an unterschiedlichen Stellen einer Elektrode, wie sie bislang beispielsweise durch Segmentierung der Elektrode und einer separaten Kontaktierung aller Segmente ermöglicht wurde.

Bei dem erfindungsgemäßen Verfahren werden demgegenüber nicht einzelne Segmente separat kontaktiert und die entsprechenden Potentialdifferenzen einzeln abgegriffen, sondern es wird eine sequentielle Schaltung angewandt, bei der mehrere Segmente, insbesondere matrixförmig angeordnete Segmente, jeweils einmal reihen-, und einmal spaltenweise in Serie kontaktiert werden.

Das Prinzip einer zweidimensionalen Anordnung von Zellen und deren zeilen- und spaltenweise Erfassung ist prinzipiell schon aus vielen Anwendungen bekannt, wie beispielsweise aus der DE 696 25 082 T2.

Bei einer 5 x 5 Matrix von Segmenten bedeutet dies, dass anstelle von bislang 25 benötigten einzelnen Drähten (2 pro Segment) nunmehr nur fünf reihenweise und fünf spaltenweise angeordnete Drähte benötigt werden. Je größer die Matrix gewählt wird, desto größer ist die Einsparung an erforderlichen Drähten durch das erfindungsgemäße Verfahren.

Die Spannungsinformationen der stromdurchflossenen Segmente werden jeweils an den Enden der reihen- und spaltenweise angeordneten Drähte abgegriffen.

Die Drähte selbst weisen einen Widerstand auf, so dass die an einem Segment auftretende Potentialdifferenz beim Abgriff an den Drahtenden eine Änderung erfährt. Aus messtechnischen Gründen ist es vorteilhaft, wenn die Drähte einen Widerstand aufweisen, der in der Größenordnung des Segmentwiderstandes liegt. Unter Segmentwiderstand ist dabei der Widerstand senkrecht zur Platte gemeint. Als geeignete Drähte mit einem solchen Widerstand sind neben Kupferdrähten auch Fäden aus Kunststoff oder Baumwolle zu nennen, die entsprechend mit einer dünnen Metallschicht beschichtet sind.

Jede Stromdichteverteilung über die einzelnen Segmente führt zu einer charakteristischen Spannungsverteilung an den Drahtenden. Mathematisch kann daher aus der Verteilung der Spannungsdifferenzen an den Drahtenden, beispielsweise über inverse Matrizen, auf die Stromdichteverteilung innerhalb der Segmente zurückgeschlossen werden. Je weiter die Drahtenden von der Messstelle, d. h. dem kontaktierten Segment entfernt liegen, desto ungenauer wird in der Regel die Messung. Daher werden die reihen- und spaltenweise angeordneten Drähte insbesondere bei größeren Matrices, beispielsweise größer als 5 x 5, beidseitig über die Platte hinweg geführt.

Ferner ist die Verwendung von wenigstens einem Referenzsegment vorgesehen. Bei dem Referenzsegment sind zusätzlich zwei separate Drähte zur Kontaktierung vorgesehen. Über den Spannungsabgriff dieser Drähte kann für das Referenzsegment eine exakte Stromdichte ermittelt werden.

Diese absolute Stromdichte fließt anschließend bei der Auswertung der Stromdichteverteilung für die gesamte Matrix in die Berechnung ein. Durch Wahl weiterer Referenzsegmente kann die Genauigkeit des Verfahrens verbessert werden, allerdings auf Kosten des eingesparten Verkabelungsaufwandes.

Das erfindungsgemäße Verfahren wird für die Bestimmung der Stromdichteverteilung in einer Brennstoffzelle, bzw. einem Brennstoffzellenstapel genutzt. Dabei kann einerseits eine segmentierte Anode oder Kathode als Segmentmatrix verwendet werden. Ferner ist aber auch der Einsatz einer zusätzlichen, segmentierten leitfähigen Platte denkbar, die beispielsweise zwischen eine bipolare Platte und eine Endplatte einer Brennstoffzelle angeordnet ist. Eine solche Vorrichtung kann vorteilhaft die Informationen zur Stromdichteverteilung einer Elektrode liefern, ohne dass eine der Elektroden selbst segmentiert werden muss.

Durch den Einsatz unterschiedlich stark segmentierter zusätzlicher Platten, kann vorteilhaft die Stromdichteverteilung einer Brennstoffzelle mit unterschiedlicher Genauigkeit ermittelt werden, ohne dass an der eigentlichen Membran-Elektrodeneinheit der Brennstoffzelle etwas verändert werden muss.

Die Vorteile des erfindungsgemäßen Verfahrens lassen sich wie folgt zusammenfassen:
- trotz Verwendung einer großen Anzahl an Segmenten bleibt der Verkabelungsaufwand vergleichsweise gering.
- Durch den Einsatz weiterer Referenzsegmente wird die Genauigkeit der Auswertung deutlich verbessert.
- Bei gleichem Verkabelungsaufwand kann mit dem Verfahren eine höhere Auflösung der Stromdichteverteilung als bislang erzielt werden.
- Beim Einsatz in einer Brennstoffzelle wird diese in ihrer Betriebsführung aufgrund des geringen Verkabelungsaufwandes kaum beeinträchtigt.

Durch die verbesserte Ermittlung von Stromdichteverteilungen werden auf einfache Weise vorteilhafte Optimierungen der Betriebsführungen einer Brennstoffzelle ermöglicht.

### Spezieller Beschreibungsteil

Nachfolgend wird der Gegenstand der Erfindung anhand eines Ausführungsbeispiels und von einer Figur näher erläutert.

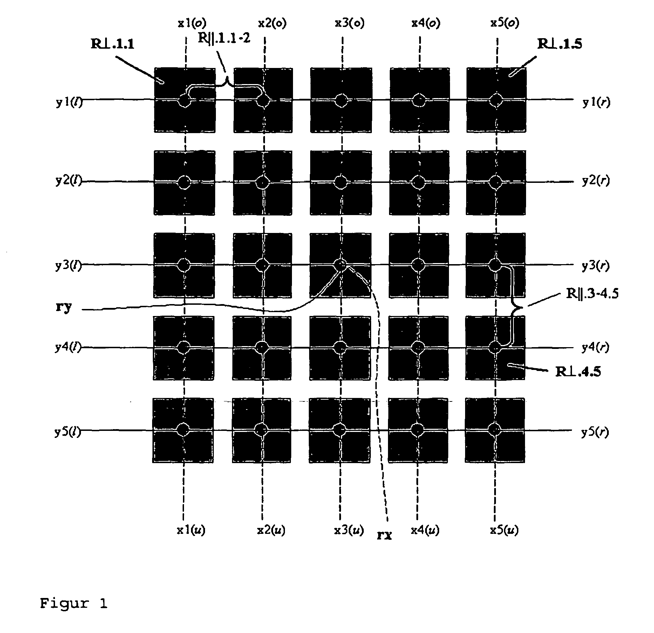

In einer vorteilhaften Ausgestaltung wurde die Stromdichteverteilung in einer einzelnen PEM-Brennstoffzelle über eine zusätzliche segmentierte Platte bestimmt, wie sie in der Figur zu sehen ist. Eine leitfähige Platte aus expandiertem Graphit mit einer Stärke von 0,1 cm und ähnlichen Abmessungen wie die Brennstoffzelle wird als Widerstandsnetzwerk eingesetzt. Die Graphitplatte umfasst 25 gleichgroße Segmente derart, dass sich eine 5 x 5 Matrix ergibt. Die Segmente selbst sind durch isolierendes Material von den benachbarten Segmenten getrennt. Eine solche segmentierte Platte ist schematisch in der Figur dargestellt. Darin bedeuten:
- ⊥: = senkrecht zur Oberfläche
- ∥: = parallel zur Oberfläche
- R: = elektrischer Widerstand
- rx, ry: = Kontaktdrähte zum Referenzpunkt
- l, r: = links, rechts
- o, u: = oben, unten
- ―: auf der Vorderseite der Platte
- -----: auf der Rückseite der Platte

Jedes Segment weist einen elektrischen Widerstand ***R* ⊥ *x.y*** senkrecht zur Platte auf, wobei ***x*** die Reihe des Segments und ***y*** die Spalte des Segments in der Matrix angibt. Beispielhaft wurden ***R*⊥ *1.1.*** und ***R*⊥ *.4.5*** explizit in die Figur eingetragen.

Alle Segmente der ersten Reihe ***.1.1*** bis ***.1.5*** sind über einen Kupferdraht ***y1*** kontaktiert und mit einander verbunden. Der Kupferdraht reicht beidseitig über die Platte hinaus. Das rechte und das linke Drahtende sind mit ***y1(l)*** und ***y1(r)*** gekennzeichnet (l = links und r = rechts). Entsprechend der Anzahl der Reihen der Matrix sind in diesem Fall fünf Drähte ***y1*** bis ***y5*** reihenweise angeordnet. Diese bilden jeweils den ersten Kontakt eines jeden Segments.

Für den zweiten Kontakt sind alle Segmente analog zur vorgenannten Art und Weise kontaktiert, mit dem Unterschied, dass nun eine spaltenweise Verknüpfung erfolgt. So sind die Segmente der ersten Spalte ***.1.1*** bis ***.5.1*** gemeinsam über den spaltenweise angeordneten Draht ***x1*** kontaktiert, der die Enden ***x1(u)*** und ***x1(o)*** aufweist (u = unten und o = oben).

Vorteilhaft erfolgt die Kontaktierung über die reihenweise angeordneten Drähte auf einer ersten Seite und über die spaltenweise angeordneten Drähte auf der entsprechend anderen Seite der Platte. Dies wird im vorliegenden Fall durch die durchgezogenen Linien für die Drähte oberhalb der Platte und durch gestrichelt ausgeführte Linien für die Drähte unterhalb der Platte angedeutet.

In diesem Ausführungsbeispiel wurde das Segment ***.3.3*** als Referenzsegment ausgewählt und über die Drähte ***rx*** und ***ry*** zusätzlich separat kontaktiert, von denen ebenfalls ***ry*** auf der Oberseite und ***rx*** auf der Unterseite der Platte angeordnet sind.
Zusätzlich sind noch die parallel zur Oberfläche der Platte auftretenden elektrischen Widerstände ***R*∥*.x.y*** eingetragen, die sich durch die Drahtverbindungen zwischen zwei Kontaktpunkten ergeben. So beispielsweise **R**∥**.1.1-2.** Damit ist der Widerstand des Drahtes parallel zur Oberfläche der Platte gemeint, der zwischen den Kontaktpunkten der Segmente ***.1.1*** und ***.1.2*** auftritt.

In der Anmeldung zitierte Literatur:
[1] Ch. Wieser, A. Helmbold, E. Gülzow in "A new technique for twodimensional current distribution measurements in electrochemical cells", Journal of Applied Electrochemistry 30 (2000) 803-807.
[2] D.J.L. Brett, S. Atkins, N.P. Brandon, V. Vesovic, N. Vasileiadis, A.R.Kucernak, Electrochemistrry Communications, 3 (2001) 628.
[3] J. Stumper, S.A. Cambell, D.P. Wilkinson, M.C. Johnson, M. Davis in "In-situ methods for the determination of current distributions in PEM fuel cells", Electrochimica Acta, Vol. 43, No. 24 (1998) 3773-3783.
[4] M. M. Mench, C.Y.J. Wang, The Electrochemical Society 150(1) (2003) A79.
[5] M. Noponen, T. Mennolan, M. Mikkola, T. Hottinen, P. Lund, J. Power Sources 106 (2002) 304.
[6] N. Rajalakshmi, M. Raja. K.S. Dhaththreyan, J. Power Sources 112 (2002) 331.
[7] S. Schönbauer, T. Kaz, H. Sander, E. Gülzow, Proceedings 2^{nd} European PEFC Forum, Licern, Schweiz 1 (2003) 231.
[8] S.J.C. Cleghorn, C.R. Derouuin, M.S. Wilson, S. Gottesfeld in "A printed circuit board approach to measuring current distribution in a fuel cell", Journal of Applied Electrochemistry 28 (1998) 663-672.
[9] Young-Gi Yoon, Won-Yong Lee, Tae-Hyun Yang, Gu-Gon Park Chang-Soo Kim in "Current distribution in a single cell of PEMFC", Journal of Power Sources 118 (2003) 193-199.

## Patentansprüche

1. Verfahren zur Bestimmung der Stromdichteverteilung in einer Brennstoffzelle oder einem Brennstoffzellenstapel,
mit den Schritten
- bei einer innerhalb der Brennstoffzelle angeordneten matrixförmig segmentierten, leitfähigen Platte wird jedes Segment durch jeweils zwei Kabel über Drähte elektrisch kontaktiert, wobei jeweils alle in einer Reihe angeordneten Segmente für einen ersten Kontakt über einen reihenweise geführten Draht y kontaktiert sind, und alle in einer Spalte angeordneten Segmente für einen zweiten Kontakt über einen spaltenweise geführten Draht x kontaktiert sind,
- wenigstens ein Segment, welches als Referenz dient, wird zusätzlich durch zwei separate Kontaktdrähte ***rx*** und ***ry*** kontaktiert,
- ein durch die Segmente fließender Strom erzeugt jeweils eine Potentialdifferenz in einem Segment,
- die Potentialdifferenzen aller Segmente führt bei den reihen- und spaltenweise geführten Drähten jeweils zu einer Spannungsdifferenz, die an den Enden der Drähte abgegriffen wird,
- zusätzlich wird die Spannungsdifferenz an den beiden separaten Kontaktdrähten des Referenzsegments abgegriffen,
- aus der Verteilung der Spannungsdifferenzen an den Drahtenden der reihen- und spaltenweise geführten Drähten wird die Stromdichteverteilung innerhalb der Segmente bestimmt, wobei die Stromdichteverteilung des Referenzsegments in die Auswertung einfließt.

2. Verfahren nach vorhergehendem Anspruch 1,
bei dem eine segmentierte Platte eingesetzt wird, bei der die reihen- und spaltenweise geführten Drähte jeweils auf gegenüberliegenden Seiten der Platte angeordnet sind.

3. Verfahren nach einem der vorhergehenden Ansprüche 1 bis 2,
bei dem eine segmentierte Platte eingesetzt wird, die wenigstens vier Segmente aufweist.

4. Verfahren nach einem der Ansprüche 1 bis 3,
bei dem Drähte eingesetzt werden, die einen Widerstand aufweisen, die in der Größenordnung der Segmentwiderstände liegen.

5. Verfahren nach einem der Ansprüche 1 bis 4,
bei dem Kupferdrähte eingesetzt werden.

6. Verfahren nach einem der Ansprüche 1 bis 5,
bei dem als Referenzsegment wenigstens ein innen liegendes Segment ausgewählt wird.

## Claims

1. Method of determining the current density distribution in a fuel cell or fuel cell stack, comprising the steps
- in a conductive plate segmented in a matrix arranged within the fuel cell, each segment is contacted electrically by two respective cables via wires, all of the segments arranged in a row for a first contact being contacted via a wire y guided in rows and all of the segments arranged in a column for a second contact being contacted via a wire x guided in columns,
- at least one segment which serves as a reference is additionally contacted by two separate contact wires rx and ry,
- a current flowing through the segments produces respective potential differences in the segments,
- the potential differences of all of the segments lead to respective voltage differences in the wires guided in rows and in columns, tapped at the ends of the wires,
- the voltage difference is additionally tapped at the two separate contact wires of the reference segment,
- the current density distribution within the segments is determined from the distribution of the voltage differences at the ends of the wires guided in rows and in columns, the current density distribution of the reference segment having some influence on the evaluation.

2. Method according to the preceding claim 1, in which a segmented plate in which the wires guided in rows and in columns are arranged on opposite sides of the plate is used.

3. Method according to one of the preceding claims 1 to 2, in which a segmented plate having at least four segments is used.

4. Method according to one of claims 1 to 3, in which wires displaying resistance of the order of the segment resistance are used.

5. Method according to one of claims 1 to 4, in which copper wires are used.

6. Method according to one of claims 1 to 5, in which at least one internal segment is selected as the reference segment.

## Revendications

1. Procédé de détermination de la distribution de la densité de courant dans une pile à combustible ou dans un groupe de piles à combustible, avec les étapes suivantes :
- pour une plaque conductrice segmentée sous forme de matrice et placée à l'intérieur de la pile à combustible, chaque segment entre en contact électrique par des fils, via respectivement deux câbles, tous les segments placés dans une série étant respectivement contactés via un fil y acheminé en série pour un premier contact, et tous les segments placés dans une colonne étant contactés via un fil x acheminé en colonne pour un deuxième contact ;
- au moins un segment servant de référence est en plus contacté par deux fils de contact rx et ry distincts ;
- un courant circulant à travers les segments produit à chaque fois une différence de potentiel dans un segment ;
- les différences de potentiel de tous les segments entraînent à chaque fois, pour les fils acheminés en série et en colonne, une différence de tension prélevée aux extrémités des fils ;
- la différence de tension est, de plus, prélevée au niveau des deux fils de contact distincts du segment de référence ;
- à partir de la distribution des différences de tension au niveau des extrémités des fils acheminés en série et en colonne, la distribution de la densité de courant est définie à l'intérieur des segments, la distribution de la densité de courant du segment de référence entrant alors dans l'évaluation.

2. Procédé selon la revendication 1 dans lequel une plaque segmentée est utilisée, plaque pour laquelle les fils acheminés en série et en colonne sont respectivement placés sur les côtés opposés de la plaque.

3. Procédé selon l'une quelconque des revendications 1 à 2 dans lequel une plaque segmentée est utilisée et présente au moins quatre segments.

4. Procédé selon l'une quelconque des revendications 1 à 3 dans lequel des fils sont utilisés et présentent une résistance du même ordre de grandeur que la résistance du segment.

5. Procédé selon l'une quelconque des revendications 1 à 4 dans lequel des fils de cuivre sont utilisés.

6. Procédé selon l'une quelconque des revendications 1 à 5 dans lequel au moins un segment interne est sélectionné comme segment de référence.
